Europäisches Patentamt

European Patent Office

Office européen des brevets

(19)

(11) Publication number : **0 617 142 A1**

(12) ## EUROPEAN PATENT APPLICATION

(21) Application number : 94302160.0

(22) Date of filing : 25.03.94

(51) Int. Cl.⁵ : **C23C 16/40, C23C 16/50**

(30) Priority : 26.03.93 JP 92205/93
03.12.93 JP 339522/93

(43) Date of publication of application :
**28.09.94 Bulletin 94/39**

(84) Designated Contracting States :
**DE FR GB**

(71) Applicant : **SHIN-ETSU CHEMICAL CO., LTD.**
**6-1, Ohtemachi 2-chome**
**Chiyoda-ku Tokyo (JP)**

(72) Inventor : **Koinuma, Hideomi**
**17-6, Ogikubo 4-chome**
**Suginami-ku, Tokyo (JP)**
Inventor : **Hongu, Tatsuhiko**
**23-3, Shimoda-cho 3-chome,**
**Kohoku-ku**
**Yokohama-shi, Kanagawa-ken (JP)**
Inventor : **Hayashida, Akira**
**31-11, Hagiyama-cho 1-chome**
**Higashimurayama-shi, Tokyo (JP)**

(74) Representative : **Stoner, Gerard Patrick et al**
**MEWBURN ELLIS**
**York House**
**23 Kingsway**
**London WC2B 6HP (GB)**

(54) **Preparation of silica thin films.**

(57)  A silica thin film is formed by establishing an atmospheric pressure glow discharge beam plasma using an inert gas as a main gas, feeding a silane compound, typically tetramethoxysilane in vapor form to the plasma, and depositing a silica thin film on a substrate, typically a plastic film. The method enables to deposit a silica thin film of quality on various substrates in the ambient atmosphere, at relatively low temperatures and within a short time.

# FIG.1

This specification relates to methods for depositing a homogeneous silica thin film on substrates.

Prior Art

Silica thin films are not only useful as insulating films and passivation films in the LSI field, but also effective in imparting resistance against wear, impact, corrosion and heat to various substrates. They are also used for decoration purposes.

There are known a number of techniques for producing such silica thin films including a traditional technique of melting silica powder followed by forming and cooling. Great advances have recently been made in this field as seen from the development of new techniques such as chemical vapor deposition and sol-gel techniques. These latest techniques are advantageous in forming homogeneous thin films of high purity on desired substrates.

Among these, a conventional chemical gas phase deposition technique using a plasma is effective for forming silica thin films, but requires very high temperatures which can cause serious damages to substrates. The substrate which can be used in this technique is limited to a highly heat resistant one. A technique using a low-temperature plasma is known to avoid such inconvenience. Plasma generating means and a substrate must be kept in vacuum before plasma treatment can be carried out. Then the low - temperature plasma technique has problems that a large size apparatus and a number of peripheral equipment are necessary and continuous treatment of substrates is difficult. The sol-gel technique also has problems including a long time taken for gel drying and difficulty to form a precise thin film because pinholes and cracks occur and voids are left during volatilization of the solvent.

Silica-deposited plastic films, wherein a silica thin film is formed on a plastic film surface are known, and useful for food wrapping and other packaging materials because they are transparent and highly resistant against air and moisture permeation as disclosed in US-A-3,442,686 and Japanese Patent Publication (JP-B) No. 12953/1978. Silica is evaporated or deposited onto a plastic film surface typically by induction heating, resistance heating, sputtering, or electron beam heating.

However, since plastic films have little resistance to heat, silica evaporation must be carried out in vacuum in order to avoid damage to the plastic films. This again imposes necessity for a number of peripheral equipment, including a high power vacuum system, and renders continuous treatment of plastic films difficult. In addition, silicon monoxide used as an evaporation source material is expensive. Other source materials such as metallic silicon dioxide lack uniformity and homogeneity because they are solid so that it is difficult to establish a stable evaporation rate, resulting in a deposited film varying in thickness and quality.

Therefore, a general aim herein is to provide novel methods for depositing a silica thin film on a substrate, preferably in the ambient atmosphere and preferably within a short time. Another aim is to provide a silica thin film preparing method suitable for producing a silica-deposited plastic film.

We have found that a silica thin film can be deposited on a substrate, even at substantially atmospheric or ambient pressure, by creating a glow discharge beam plasma using an inert gas as a main gas and feeding a silane compound of the general formula (1):

$$R^1_n Si(OR^2)_{4-n} \qquad (1)$$

wherein $R^1$ is a hydrogen atom, lower alkyl group or lower alkoxy group, $R^2$ is a lower alkyl group, and n is an integer of 0 to 4, in vapor form to the plasma, whereby the glow discharge beam plasma causes conversion of the silane compound into silica. This silica thin film was firmly deposited on any of various substrates. We got a homogeneous, good quality film free of pinholes and cracks. Particularly when a silica thin film of 0.01 to 1 $\mu$m thick is deposited on a plastic film as a typical substrate, we can obtain a silica-deposited plastic film characterized by transparency, flexibility and gas barrier property. The process is effective at or near atmospheric pressure.

BRIEF DESCRIPTION OF THE DRAWINGS

FIG. 1 schematically illustrates one exemplary atmospheric pressure glow discharge beam plasma generating system.

FIG. 2 is a photomicrograph of a silica thin film deposited on a single crystal silicon substrate in Example 1.

FIG. 3 is a diagram showing the IR absorption spectrum of a silica thin film deposited on a single crystal silicon substrate, curve (a) being that of the silica thin film in Example 1 and curve (b) being that of a silica thin film resulting from air oxidation.

FIG. 4 is a graph showing the deposition rate per second of silica thin film as a function of hydrogen feed rate.

FIG. 5 is a graph showing the O/Si atom ratio and C content in silica thin film as a function of hydrogen feed rate.

FIG. 6 is a graph showing the Vickers hardness of silica thin film as a function of hydrogen feed rate.

The method for preparing a silica thin film disclosed herein involves the steps of: creating a glow discharge beam plasma using an inert gas as a main gas; feeding a silane compound of the general formula (1):

$$R_n^1 Si(OR^2)_{4-n} \qquad (1)$$

wherein $R^1$ is a hydrogen atom, lower alkyl or alkoxy group, $R^2$ is a lower alkyl group, and n is an integer of 0 to 4, in vapor form to the plasma; and depositing a silica thin film on a substrate. "Lower" is generally $C_{1-6}$, preferably $C_{1-4}$.

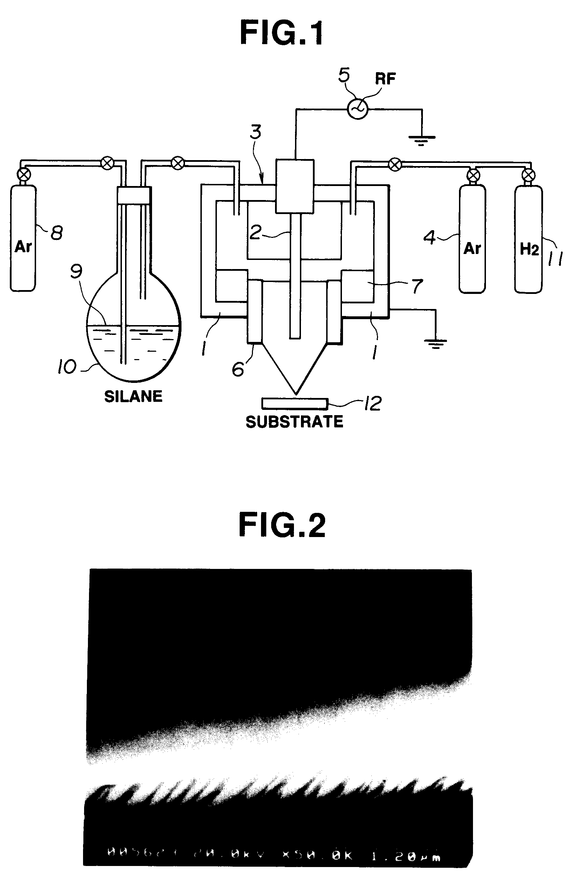

A silica thin film is formed from a silane compound under the action of an atmospheric pressure glow discharge beam plasma. Apparatus for making an ambient/atmospheric pressure glow discharge plasma is disclosed in Koinuma et al., JP-A 212253/1992, JP-A 242924/1992, and Appl. Phys. Lett., 60 (7), 17 Feb., 1992. An exemplary useful plasma apparatus is illustrated in FIG. 1.

Preferably a main gas is passed through the plasma apparatus, and an RF oscillator is actuated to generate a plasma. A silane compound vapor optionally entrained on a carrier gas is fed to the apparatus for reaction in a plasma flame. If desired, hydrogen gas may be introduced as a reaction gas.

The power of the RF oscillator varies depending on the configuration of a plasma torch, the size of a plasma flame, and the type of a main gas although a power of about 50 to 150 W is preferred for a plasma flame of 5 mm in diameter. No plasma would be generated at a lower power whereas a higher power would be uneconomical and can damage the electrodes.

The main gas used herein is preferably noble e.g. helium and/or argon. The amount of the main gas fed varies depending on its type, the configuration of a plasma torch, and the size of a plasma flame although a rate of 200 to 300 SCCM (standard cubic centimeter) is preferred for a plasma flame of 5 mm in diameter. No plasma would be generated with a smaller amount.

The silane compound used herein is of the general formula (1).

$$R_n^1 Si(OR^2)_{4-n} \qquad (1)$$

In formula (1), $R^1$ is a hydrogen atom, a lower alkyl group (e.g., methyl) or a lower alkoxy group, and $R^2$ is a lower alkyl group, with alkyl and alkoxy groups having 1 to 4 carbon atoms being preferred. Letter n is an integer of 0 to 4. Since the silane compound is fed in vapor form, those silane compounds which are gaseous at room temperature and liquid or solid silane compounds having an appreciable vapour pressure at room temperature are preferred. Volatile silane compounds are most preferred.

Preferred examples of the silane compound include tetramethoxysilane, tetraethoxysilane, trimethoxysilane, triethoxysilane, and methyltrimethoxysilane, with the tetramethoxysilane having the highest vapor pressure being most preferred among others.

The source silane compound should be of high purity in order to give a good quality silica thin film. In general, silane compounds can be readily purified by distillation.

The amount of the silane compound gas fed varies depending on the configuration of a plasma torch, the size of a plasma flame, and the type of a main gas although a rate of 0.01 to 2 SCCM, especially 0.2 to 1 SCCM is preferred for a plasma flame of 5 mm in diameter. Below the range, deposition may become less efficient, resulting in low productivity. Beyond the range, silica particles may join together upon deposition to form a rough porous film.

Preferably the silane compound gas is fed to the plasma generator apparatus as shown in FIG. 1 by bubbling a carrier gas into the silane compound liquid at a certain temperature whereby the silane compound evaporates to its vapor pressure at that temperature. The silane compound vapor at the vapor pressure is fed to the plasma generator apparatus. By controlling the feed rate of the carrier gas, the feed rate of the silane compound gas can be controlled.

The silane compound in gas or vapor form is fed to the atmospheric pressure glow discharge beam plasma apparatus where the gas is excited by the plasma and converted into silica which deposits on a substrate in the ambient atmosphere. This operation is simply continued for a time necessary to achieve a desired thickness.

While the deposition rate of silica thin film depends on the feed rate of the silane compound gas, silica is preferably deposited at a rate of about 50 to 500 Å/sec., especially about 100 to 200 Å/sec. in order to produce a homogeneous and dense silica thin film.

In the practice of the technique, it is recommended to feed hydrogen gas along with the silane compound gas because formation of a more homogeneous and higher quality silica thin film is then expected.

The feed rate by volume of hydrogen gas is preferably 0 to about 50 times, especially about 10 to about 30 times the feed rate by volume of the silane compound vapor. Formation of a silica thin film is possible without supply of hydrogen gas. When hydrogen gas is fed, its feed rate by volume is preferably about 10 times the feed rate by volume of the silane compound vapor because a lower feed rate of hydrogen gas may cause an increase of carbon content and a lowering of hardness, despite an increased deposition rate. A preferred upper limit of hydrogen feed rate is 50 times the feed rate by volume of the silane compound vapor because a higher feed rate of hydrogen gas tends to obstruct its addition effect and render the plasma flame unstable.

In order to impart gas barrier properties to a silica thin film - bearing plastic film, it is preferred that the silica thin film has an oxygen/silicon ratio of up to 1.8 in atomic ratio. Gas barrier properties would become low at a higher oxygen/silicon ratio. It is then recommended to control the feed rate by volume of hydrogen gas to be about 10 to about 20 times the feed rate by volume of the silane compound vapor so that the resulting silica thin film may have an oxygen/silicon atom ratio of up to 1.8.

As previously described, a carrier gas may be used in the practice of the technique. The carrier gas is used for the purpose of feeding the silane compound gas. It may be the same as the main gas (such as helium and argon), or the reaction gas (such as hydrogen gas): an inert gas such as nitrogen is also a useful carrier gas. Since the feed rate of the carrier gas varies with the vapor pressure of the silane compound, it cannot be limited to a certain range, but may be a minimum feed rate necessary to assist in feeding the silane compound gas.

The type of substrate on which a silica thin film can be deposited and formed according to the invention is not critical. Included are single crystal silicon, metal substrates such as aluminum and stainless steel, ceramic substrates such as silicon nitride, alumina, and boron nitride, carbonaceous substrates such as graphite, and plastic substrates such as polyethylene, polypropylene, polycarbonates, polyesters, polyamides, polyimides, phenolic resins, polyurethanes, polyvinyl alcohol, polyacrylonitrile, cellophane, polyvinyl halides, polyvinylidene halides, and epoxy resins.

During plasma treatment, the substrate is usually heated e.g. to about 200°C. Those substrates which are stable at temperatures of higher than 200 °C in the ambient atmosphere may be used as such. Some substrates, for example, polyethylene and polypropylene substrates can be melted, decomposed or even oxidized and burnt at a temperature of 200 °C in the ambient atmosphere. These less heat resistant substrates should be cooled during plasma treatment.

When it is desired to manufacture a gas barrier film by depositing a silica thin film on a plastic film as the substrate in accordance with the present method, the silica thin film should preferably be about 0.01 to 1 μm thick. A silica thin film with a thickness of less than 0.01 μm is usually ineffective for providing a gas barrier whereas a film with a thickness of more than 1 μm is liable to cracking and stripping during handling, losing gas barrier properties.

The thickness of the plastic film may be suitably selected depending on a particular application. Where a silica deposited plastic film is used as a gas barrier packaging material, a plastic film of about 5 to 500 μm thick will meet the requirement of flexibility.

The silica thin film forming method utilizing an atmospheric pressure glow discharge beam plasma enables flexibility in process conditions e.g. so that a silica thin film may be deposited on any substrate in the atmospheric air, without the need for a large size apparatus such as a vacuum system and complex peripheral equipment, with a good deposition rate and continuous treatment of substrates, and with good manufacturing efficiency. Possible deposition at relatively low temperatures allows for selection of the substrate from a wide variety of materials. The method may be used for imparting resistance against wear, impact, corrosion and heat to substrates and even for decoration purposes. When a high purity silane compound is used as a source, there can be formed a silica thin film of quality which is homogeneous, highly pure, and free of pinholes, cracks, and voids. No tendency to damage the substrate has been noted. Methods disclosed herein may be useful in the field of electronic materials where high quality is required as well as the field of packaging plastic films where transparency, flexibility and gas barrier properties are required.

Examples of the present invention are given below by way of illustration and not by way of limitation.

Example 1

Using a system as shown in FIG. 1, a silica thin film was deposited on a single crystal silicon substrate. The system included a plasma generator 3 equipped with an anode 1 and a cathode 2, an insulator 6 defining a plasma torch, and a spacer 7.

While 300 SCCM of argon gas (main gas) was passed through the plasma generator 3 from an argon gas source 4, an RF oscillator 5 having a frequency of 13.56 MHz and a power of 90 W was actuated to generate a plasma.

Next 5 SCCM of argon gas (carrier gas) from an argon gas source 8 was passed to a bubbler 10 charged with a tetramethoxysilane liquid 9 for generating tetramethoxysilane vapor. A mixture of tetramethoxysilane vapor and argon gas was fed to the plasma generator 3. At the same time, 5 SCCM of hydrogen gas was fed to the plasma generator 3 from a hydrogen gas source 11. The feed rate of tetramethoxysilane vapor was 0.2 SCCM as calculated from its vapor pressure.

A single crystal silicon substrate 12 was disposed below the plasma torch of the plasma generator 3 at a spacing of 2 mm. While the substrate 12 was held in place for one minute, a silica (silicon dioxide) thin film deposited thereon. The thus deposited silica thin film firmly adhered to the substrate and could not be readily stripped therefrom.

FIG. 2 is a photomicrograph (magnifying power × 20,000) of this silica thin film, showing that the silica thin film is homogeneous and dense.

The silica thin film was measured for thickness by means of a surface roughness meter, Dektak 3030. Its thickness was 0.7 μm, from which a deposition rate of 117 Å/sec. was calculated.

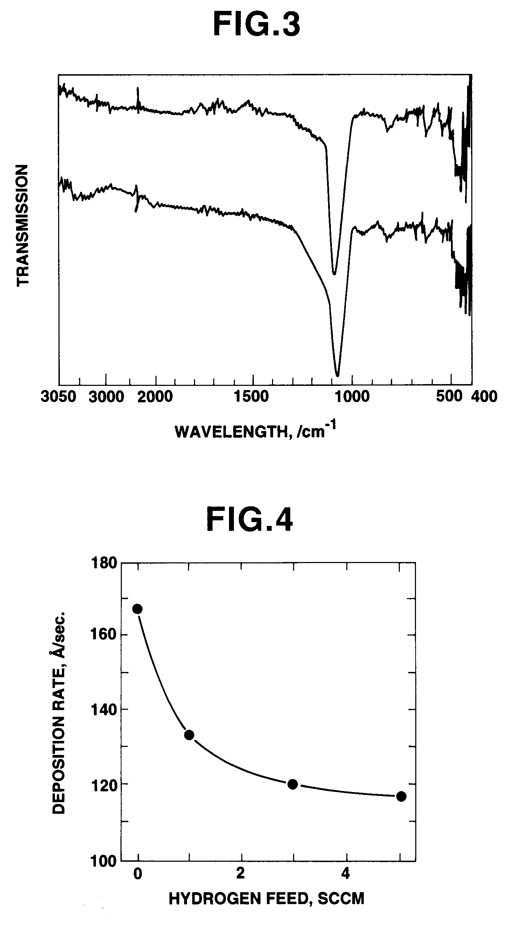

Shown in FIG. 3 as curve a is the IR absorption spectrum of the silica thin film. Curve b is the spectrum of a silica thin film which was formed on a single crystal silicon substrate by air oxidation at 1,000°C for one hour. It is seen that the IR absorption spectrum of the present silica thin film is coincident with that of the air oxidized one.

By X-ray photoemission spectroscopy, the silica thin film was measured for an oxygen/silicon ratio and carbon content. The oxygen/silicon ratio (atom ratio) was 1.9 which was approximately equal to that of silica glass, and the carbon content was as low as 0.98%.

On hardness measurement using a ultrafine hardness meter manufactured by Shimazu Mfg. K.K., the silica thin film was found to have a hardness equal to that of Corning #7059 glass.

## Examples 2-4

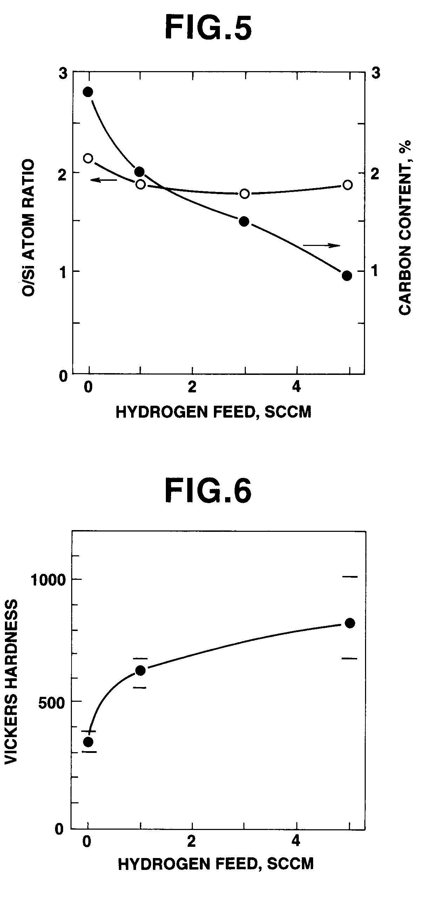

By following the procedure of Example 1 except that the feed rate of hydrogen gas was changed to 0, 1 and 3 SCCM, silica thin films were deposited on single crystal silicon substrates. The thin films were similarly measured for deposition rate, oxygen/silicon ratio (atom ratio), carbon content, and hardness. The results are shown in FIGS. 4, 5, and 6.

These graphs indicate the tendency that as the hydrogen feed rate is decreased, the deposition rate increases, but the carbon content increases and the hardness lowers.

## Examples 5-6

By following the procedure of Example 1 except that substrates of silicon nitride and Corning #7059 glass were used, silica thin films were deposited on single crystal silicon substrates. The silica thin films firmly adhered to the substrates and could not be readily stripped therefrom.

## Examples 7-12

Each of the plastic films shown in Table 1 was closely rested on an aluminum container which was filled with ice water. The feed rate of hydrogen is shown in Table 1. As in Example 1, each plastic film was held under the plasma torch for 10 seconds, during which period a silica thin film deposited on the plastic film. The thus silica deposited plastic films remained flexible. The silica deposits firmly adhered to the plastic films and could not be readily stripped therefrom.

The silica deposited plastic films (Examples 7-12) and a polypropylene film having no silica deposited thereon (Control) were measured for oxygen permeability by a vacuum-pressure technique by measuring a pressure increase on the low pressure (or vacuum) side. A coefficient of oxygen permeation was calculated, with the results reported in Table 1.

Table 1

| | Example | | | | | | Control |
|---|---|---|---|---|---|---|---|
| | 7 | 8 | 9 | 10 | 11 | 12 | |
| Plastic film | PP | PP | PP | PP | PET | PC | PP |
| Thickness, $\mu$m | 50 | 50 | 50 | 50 | 25 | 25 | 50 |
| Hydrogen feed rate, SCCM | 3 | 0 | 1 | 5 | 3 | 3 | 3 |
| Silica deposit thickness, $\mu$m | 0.11 | 0.11 | 0.11 | 0.11 | 0.12 | 0.08 | — |
| O/Si atomic ratio | 1.77 | 2.10 | 1.89 | 1.88 | 1.75 | 1.77 | — |
| Coefficient of oxygen permeation, cc·cm/cm²·sec·cmHg | $2.1 \times 10^{-14}$ | $1.1 \times 10^{-13}$ | $5.3 \times 10^{-14}$ | $4.1 \times 10^{-14}$ | $9.8 \times 10^{-15}$ | $7.7 \times 10^{-14}$ | $1.8 \times 10^{-10}$ |

PP: polypropylene

PET: polyethylene terephthalate

PC: polycarbonate

Although some preferred embodiments have been described, many modifications and variations may be made thereto in the light of the above teachings. It is therefore to be understood that within the scope of the appended claims, the invention may be practiced otherwise than as specifically described.

**Claims**

1.  A method for preparing a silica thin film comprising the steps of:
    creating an atmospheric pressure glow discharge beam plasma using an inert gas as a main gas,
    feeding a silane compound of the general formula (1):
    $$R_n^1 Si(OR^2)_{4-n} \qquad (1)$$
    wherein $R^1$ is a hydrogen atom, lower alkyl or alkoxy group, $R^2$ is a lower alkyl group, and n is an integer of 0 to 4, in vapor form to the plasma, and
    depositing a silica thin film on a substrate.

2.  The method of claim 1 wherein said substrate is a plastic film and said silica thin film is 0.01 to 1 μm thick.

3.  The method of claim 1 or 2 which further comprises the step of feeding hydrogen gas at the same time as the silane compound.

4.  The method of claim 3 wherein the feed rate by volume of hydrogen gas is 10 to 20 times the feed rate by volume of the silane compound vapor.

# FIG.1

# FIG.2

# FIG.3

# FIG.4

# FIG.5

# FIG.6

European Patent
Office

**EUROPEAN SEARCH REPORT**

Application Number

EP 94 30 2160

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X<br>A | WO-A-92 11312 (L'AIR LIQUIDE)<br>* page 3, line 4 - page 4, line 4 *<br>--- | 1,2<br>3,4 | C23C16/40<br>C23C16/50 |
| A | EP-A-0 245 716 (POLAROID CORPORATION)<br>* page 5, line 4 - page 6, line 4 *<br>--- | 1-4 | |
| A | JOURNAL OF THE ELECTROCHEMICAL SOCIETY,<br>vol.137, no.9, September 1990, U.S.A<br>pages 2883 - 2887, XP150995<br>K. FUJINO ET AL 'SILICON DIOXIDE<br>DEPOSITION BY ATMOSPHERIC PRESSURE AND<br>LOW-TEMPERATURE CVD USING TEOS AND OZONE'<br>*EXPERIMENTAL*<br>* figure 1 *<br>--- | 1-4 | |
| A | EP-A-0 440 154 (APPLIED MATERIALS INC)<br>* page 7, line 20 - page 8, line 49 *<br>--- | 1-4 | |
| A | US-A-4 572 841 (G. KAGANOWICZ ET AL)<br>* example 1 *<br>----- | 1-4 | |

TECHNICAL FIELDS
SEARCHED      (Int.Cl.5)

C23C

The present search report has been drawn up for all claims

| Place of search | Date of completion of the search | Examiner |
|---|---|---|
| THE HAGUE | 1 July 1994 | Ekhult, H |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)